# EUROPÄISCHE PATENTANMELDUNG

(11) **EP 1 515 376 A2**
(43) Veröffentlichungstag der Anmeldung: **16.03.2005**
(21) Anmeldenummer: 04021281.3
(22) Anmeldetag: 08.09.2004
(51) Int. Cl.: H01L 35/32

(54) **Vorrichtung zur Erzeugung elektrischer Energie**

(30) Priorität: 15.09.2003 DE 10342653
(71) Anmelder: Miliauskaite, Asta, Dr., 66386 St. Ingbert (DE)
(72) Erfinder: Müller-Werth Bernhard, 66280 Sulzbach (DE)
(74) Vertreter: Bernhardt, Reinold, Dr. Dipl.Phys.

(57) **Zusammenfassung**

Die Erfindung betrifft eine Vorrichtung zur Erzeugung elektrischer Energie mit einer Vielzahl von Thermoelementen, die jeweils ein erstes Leiterstück (6), ein mit dem ersten Leiterstück verbundenes zweites Leiterstück (1;2) und ein drittes Leiterstück (6'), das mit dem zweiten Leiterstück (1;2) auf dessen dem ersten Leiterstück (6) gegenüberliegenden Seite verbunden ist, aufweist, wobei sich das Leitermaterial der ersten und dritten Leiterstücke (6,6') vom Leitermaterial der zweiten Leiterstücke (1;2) unterscheidet und die ersten Leiterstücke (6) mit einer Wärmequelle (11) und die dritten Leiterstücke (6') mit einer Wärmesenke (11') in Verbindung stehen, und eine Reihenanordnung der Thermoelemente vorgesehen ist, in welcher abwechselnd die ersten (6) und dritten (6') Leiterstücke der aufeinanderfolgenden Thermoelemente einander zugewandt sind. Gemäß der Erfindung sind die in der Reihenanordnung einander zugewandten Leiterstücke jeweils elektrisch miteinander verbunden und die zweiten Leiterstücke (1;2) der Thermoelemente abwechselnd aus einem, bezogen auf das Leitermaterial der zweiten und dritten Leiterstücke (6,6'), thermoelektrisch positiven und thermoelektrisch negativen Leitermaterial hergestellt, oder wobei die in der Reihenanordnung einander zugewandten Leiterstücke jeweils voneinander elektrisch isoliert und die dritten Leiterstücke jeweils mit dem ersten Leiterstück des in der Reihenanordnung folgenden Thermoelements elektrisch verbunden sind.

## Beschreibung

Die Erfindung betrifft eine Vorrichtung zur Erzeugung elektrischer Energie mit einer Vielzahl von Thermoelementen, die jeweils ein erstes Leiterstück, ein mit dem ersten Leiterstück verbundenes zweites Leiterstück und ein drittes Leiterstück, das mit dem zweiten Leiterstück auf dessen dem ersten Leiterstück gegenüberliegenden Seite verbunden ist, aufweist, wobei sich das Leitermaterial der ersten und dritten Leiterstücke vom Leitermaterial der zweiten Leiterstücke unterscheidet, die ersten Leiterstücke mit einer Wärmequelle und die dritten Leiterstücke mit einer Wärmesenke in Verbindung stehen, und eine Reihenanordnung der Thermoelemente vorgesehen ist, in welcher abwechselnd die ersten und dritten Leiterstücke der aufeinanderfolgenden Thermoelemente einander zugewandt sind.

Eine solche, Wärmeenergie in elektrische Energie umsetzende Vorrichtung, in welcher die Thermoelemente parallel geschaltet sind, ist aus der DE 102 00 407 A1 bekannt.

Der Erfindung liegt die Aufgabe zugrunde, eine Thermobatterie der eingangs genannten Art mit erhöhter elektrischer Leistung zu schaffen.

Gemäß der Erfindung sind die in der Reihenanordnung einander zugewandten Leiterstücke jeweils elektrisch miteinander verbunden und die zweiten Leiterstücke der Thermoelemente abwechselnd aus einem, bezogen auf das Leitermaterial der ersten und dritten Leiterstücke, thermoelektrisch positiven und thermoelektrisch negativen Leitermaterial hergestellt.

Alternativ können die einander zugewandten Leiterstücke voneinander elektrisch isoliert und die dritten Leiterstücke jeweils mit dem ersten Leiterstück des in der Reihenanordnung folgenden Thermoelements elektrisch verbunden sein.

Die Thermospannungen der in der Reihenanordnung benachbarten Thermoelemente sind gemäß beiden Alternativen gleichgerichtet und addieren sich. Eine solche Thermobatterie erlaubt es, auf unterschiedlichen Temperaturen liegende Kontaktstellen zwischen Leitern in räumlich großer Dichte anzuordnen und so eine erhöhte elektrische Leistung zu erreichen.

Die in der Reihenanordnung einander zugewandten, elektrisch miteinander verbundenen Leiterstücke können unmittelbar ineinander übergehen, d.h. einstückig vorgesehen sein, wobei solche Leiterstücke vorzugsweise durch eine Platte gebildet sind.

Zwischen den eine Stapelanordnung bildenden Platten kann jeweils eine Vielzahl von zweiten Leiterstücken angeordnet sein, so dass neben einer seriellen Schaltung von Thermoelementen auch eine Parallelschaltung vorliegt, welche den Innenwiderstand verringert und die elektrische Leistung erhöht.

In einer besonders bevorzugten Ausführungsform der Erfindung sind die zweiten Leiterstücke abwechselnd durch eine p-leitenden und einen n-leitenden Halbleiter gebildet.

Bei den zweiten Leiterstücken bzw. Halbleitern kann es sich um blockartige Teile handeln, die über eine ihrer Querschnittsfläche entsprechende Kontaktfläche mit dem ersten und zweiten Leiterstück, vorzugsweise diese Leiterstücke bildenden Platten in Verbindung stehen.

Eine Verbindung zur Wärmequelle bzw. -senke lässt sich über die Stapelanordnung durchsetzende Wärmeleitstäbe herstellen, wobei die Wärmeleitstäbe durch zueinander ausgerichtete, aufeinanderfolgende Öffnungen in den Platten geführt sind und abwechselnd im Wärmekontakt mit und wärmeisoliert gegen den Öffnungsrand, vorzugsweise im Abstand zum Öffnungsrand, durch die Öffnungen geführt sind. In der Stapelanordnung wechseln also geheizte und gekühlte Platten einander ab.

In der bevorzugten Ausführungsform der Erfindung stehen die Wärmeleitstäbe über elektrisch isolierende Wärmeleitringe im Wärmekontakt mit dem Öffnungsrand, wobei es sich vorzugsweise um abgestufte, am Öffnungsrand abstützbare Ringe handelt. Alternativ könnte eine Platte unterschiedlich weite Öffnungen aufweisen und der Öffnungsrand der engeren Öffnungen direkt den Wärmeleitstab berühren.

Vorzugsweise werden Wärmeleitstäbe eingesetzt, in denen ein wärmetransportierendes Medium fließt. Durch eine solche Wärmekonvektion lässt sich Wärme wesentlich effektiver zu- bzw. abführen als nur durch Wärmeleitung. Als Wärmeleitstäbe lassen sich insbesondere Heatpipes oder andere hochwirksame Leiteinrichtungen verwenden.

Zweckmäßig sind die Kontaktflächen der p- und n-leitenden Halbleiter quadratisch und die Öffnungen in den Platten oder Folien kreisrund. In einer besonders bevorzugten Ausführungsform sind die Öffnungen in den Platten in einem quadratischen Raster angeordnet und die verlängerten Diagonalen der Kontaktflächen der p- und n-leitenden Halbleiter halbieren die Quadratseiten. Bei dieser Anordnung wird die zur Verfügung stehende Plattenfläche weitgehend als Kontaktfläche genutzt und es lässt sich eine hohe Packungsdichte der abwechselnd warmen und kalten Kontaktstellen erreichen, wobei die warmen und kalten Kontaktstellen innerhalb der Stapelanordnung eine gleichmäßig höhere bzw. niedrigere Temperatur aufweisen.

In den Eckbereichen können die Kontaktflächen ineinander übergehen, wobei die Halbleiter jeweils an zwei Ecken entsprechende Aussparungen aufweisen.

In weiterer Ausgestaltung der Erfindung sind die genannten Platten aus mehreren Lagen gebildet. Auf diese Weise lassen sich Platten mit z.B. p- oder n-leitenden Halbleitern und Lagen auf der Ober- und Unterseite vorfertigen, was die Montage der Vorrichtung erleichtert.

Zur Verbindung der p- und n-leitenden Halbleiter mit den Platten bzw. Lagen wie auch der Lagen untereinander wird zweckmäßig eine Klebetechnik unter Verwendung leitfähiger Kleber angewandt. Neben Klebetechniken kommen auch Schweißtechniken, Bondtechniken und andere geeignete Verbindungsarten in Betracht.

Die Wärmeleitstäbe enden mit ihrem der Quelle bzw. Senke abgewandten freien Ende zweckmäßig in oder an einer zwischen der Quelle bzw. Senke und der Stapelanordnung vorgesehenen Isolierschicht, die sowohl der elektrischen als auch thermischen Isolierung dient.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: eine Schemadarstellung einer durch Halbleiter gebildeten Thermoelement-Elementarzelle,
- Fig. 2: eine Serienschaltung von Elementarzellen gemäß Fig. 1,
- Fig. 3: eine Anordnung parallel und seriell verschalteter Elementarzellen,
- Fig. 4: eine die Anordnung von Fig. 3 verwendende Thermobatterie gemäß einem ersten Ausführungsbeispiel für die vorliegende Erfindung,
- Fig. 5: ein in der Thermobatterie von Fig. 4 verwendetes Plattenteil,
- Fig. 6: eine Anordnung parallel und seriell verschalteter Elementarzellen gemäß einem zweiten Ausführungsbeispiel für die Erfindung, und
- Fig. 7: eine weitere Ausführungsform eines in einer Thermobatterie nach der Erfindung verwendbaren Plattenteils.

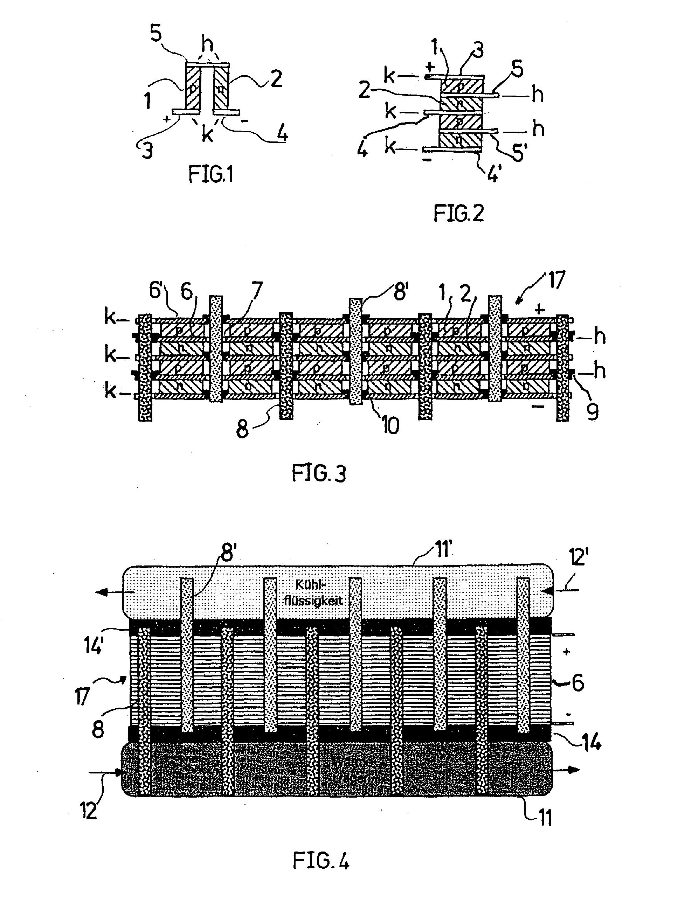

Eine in Fig. 1 zur Erläuterung der Erfindung gezeigte Elementarzelle weist einen p-dotierten Halbleiter 1 und einen n-dotierten Halbleiter 2 auf. Die Halbleiter 1 und 2 sind jeweils an einem Ende mit einem Leiterstück 3 bzw. 4 und untereinander durch ein Leiterstück 5 verbunden. Die Leiterstücke 3 bis 5 bestehen aus dem gleichen Leitermaterial, z.B. Kupfer. Zwischen den Leiterstücken 3 und 4 liegt eine elektrische Spannung an, wenn an den beiden Verbindungsstellen der Halbleiter 1 und 2 zum Leiterstück 5 eine andere Temperatur als an den beiden Verbindungsstellen der Leiterstücke 3 und 4 zu den Halbleitern herrscht. Die Thermospannungen der beiden Grundelemente der Elementarzelle sind gleichgerichtet und addieren sich.

Fig. 2 zeigt eine Reihenschaltung aus zwei solchen Elementarzellen. Die Thermospannungen beider Zellen addieren sich, wenn dafür gesorgt wird, dass die Kontaktstellen zwischen den Halbleitern 1,2,1',2' und den Leiterstücken 3,5,4,5',4' abwechselnd auf unterschiedlicher Temperatur, d.h. kalt (k) und heiß (h), gehalten werden.

Fig. 3 zeigt eine Anordnung mit einer Vielzahl sowohl seriell als auch parallel verschalteter solcher Thermoelement-Reihenschaltungen. Als Leiterstücke dienen deckungsgleiche, eine Stapelanordnung 17 bildende Platten 6 bzw. 6', welche in einem Raster angeordnete Öffnungen 7 aufweisen. Durch die zueinander ausgerichteten Öffnungen 7 ragen Wärmeleitstäbe 8 und 8', von denen die Stäbe 8 mit einer Wärmequelle und die Stäbe 8' mit einer Wärmesenke in Verbindung stehen. Quelle und Senke sind in Fig. 3 nicht gezeigt.

Die sich abwechselnden Platten 6 und 6' sind über in betreffenden Öffnungen 7 eingesetzte, elektrisch gegen die Platte oder/und Wärmeleitstäbe isolierte Kontaktringe 10 mit einem Wärmeleitstab 8 bzw. 8' verbunden. Die Kontaktringe 10 füllen jeweils einen Zwischenraum zwischen dem Wärmeleitstab und dem Rand der betreffenden Öffnung 7 aus. Das heißt, über die elektrisch isolierenden Kontaktringe 10 stehen die Platten 6 im Wärmekontakt mit der Wärmequelle, die Platten 6' im Wärmekontakt mit der Wärmesenke.

Fig. 4 zeigt eine vollständige, die Anordnung von Fig. 3 verwendende Thermobatterie. Die p- und n-leitenden Halbleiter zwischen den Platten 6 und 6' sind nicht dargestellt.

Wie aus Fig. 4 hervorgeht, enden die Wärmeleitstäbe 8 in einem die Wärmequelle bildenden Behälter 11, der gemäß Pfeil 12 von einem Wärmeträgerflüssigkeit durchströmt wird. Die Wärmeleitstäbe 8' stehen in Wärmekontakt mit einer Kühlflüssigkeit, welche gemäß Pfeil 13 durch einen die Wärmesenke bildenden Behälter 11' strömt. Die Behälter 11,11' und die Stapelanordnung 17 aus den Platten 6 und 6', zwischen denen abwechselnd p- und n-leitende Halbleiter angeordnet sind, werden jeweils durch eine thermisch und elektrisch isolierende Schicht 14 bzw. 14' voneinander getrennt.

In der beschriebenen Thermobatterie werden die Platten 6 durch den Behälter 11 und die Platten 6' durch den Behälter 11' auf unterschiedlichen Temperaturen gehalten. Entsprechend unterschiedliche Temperaturen herrschen an den flächenförmigen Kontaktstellen zwischen den p- und n-leitenden Halbleitern und den betreffenden Platten 6 bzw. 6'. Durch Reihenschaltung einer Vielzahl von Thermoelementen liegt zwischen den beiden äußersten Platten der Stapelanordnung 14 eine Thermospannung, die einem Vielfachen der durch eine einzige Elementarzelle gemäß Fig. 1 gelieferten Thermospannung entspricht. Durch zusätzliche Parallelschaltung vieler Zellen mit flächenförmig kontaktierten Halbleitern ist der Innenwiderstand der Thermobatterie gering, so dass ein starker Strom fließen und eine hohe elektrische Leistung abgegeben werden kann.

In dem gezeigten Ausführungsbeispiel sind die Wärmeleitstäbe 8,8' als Hohlkörper mit einem wärmetransportierenden Medium im Inneren ausgebildet, so dass neben einer Wärmeleitung eine noch effektivere Wärmeübertragung durch Konvektion erfolgt. Als Wärmeleitstäbe eignen sich insbesondere Heatpipes, in denen ein wärmetransportierendes Medium zwischen der Gas- und Flüssigkeitsphase wechselt.

Die Platten 6,6' und die p- und n-leitenden Halbleiter sind in dem gezeigten Ausführungsbeispiel miteinander durch ein elektrisch leitendes Klebemittel verklebt. Zur Verbindung kommen ferner Bondtechniken, Schweißtechniken und ähnliche Verbindungsarten in Betracht. An den Kontaktflächen der Halbleiter ist ferner eine Diffusionssperrschicht gebildet, die ein Überdiffundieren von Dotierungsmaterial in die Platten 6,6' verhindert.

Eine die Anordnung stabilisierende, jeweils an den Behältern 11,11' außen angreifende Halteeinrichtung, die miteinander durch Zuganker verbundene Platten aufweist, ist in den Figuren nicht gezeigt.

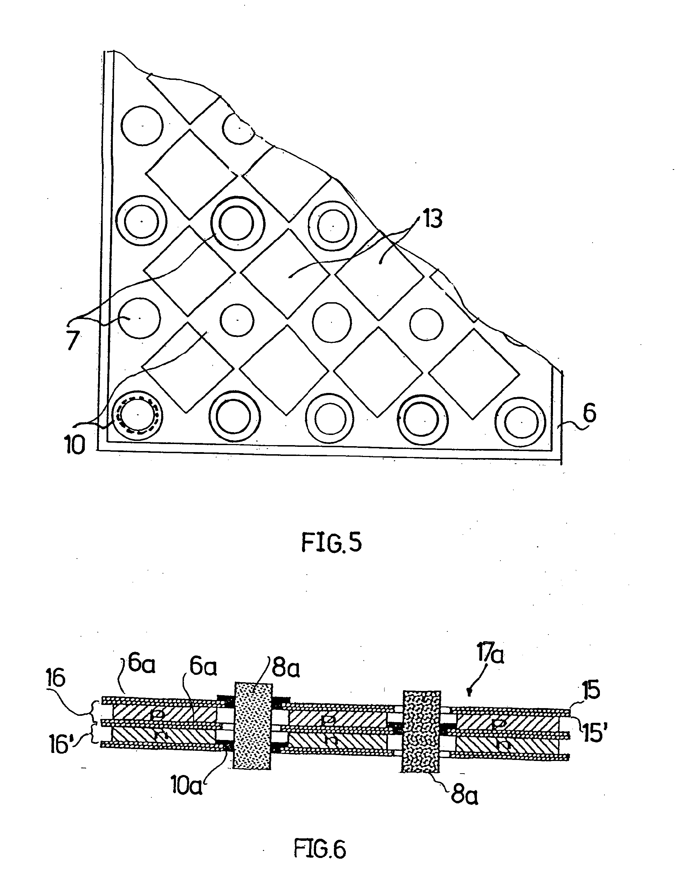

Fig. 5 zeigt ausschnittsweise eine Platte 6 bzw. 6' mit Öffnungen 7 und in einen Teil der Öffnungen 7 eingesetzte Kontaktringe 10 sowie Kontaktflächen 13 für die Verbindung mit p- oder n-leitenden Halbleitern. Die Kontaktflächen könnten durch Ränder von Einprägungen begrenzt sein. Wie Fig. 5 erkennen lässt, weisen die Halbleiter einen quadratischen Querschnitt auf. Die Querschnittsform könnte auch vom Quadrat abweichen und insbesondere rund sein. Diese Querschnittsform und die gezeigte Art der Anordnung warmer und kalter Kontaktstellen erlaubt eine größtmögliche Packungsdichte der Kontaktstellen in der Stapelanordnung.

Die Wärmekontaktringe 10 weisen einen Stufenabsatz 9 mit einem Innendurchmesser auf, der gleich dem Durchmesser der Öffnungen 7 ist.

Es versteht sich, dass auf den Platten 6' die auf den Platten 6 freien Öffnungen 7 mit Kontaktringen besetzt sind.

In dem gezeigten Ausführungsbeispiel bestehen die Platten 6,6' aus Kupfer, die Wärmekontaktringe aus Aluminium und der Außenmantel der Wärmeleitstäbe 8,8' aus Aluminium, Kupfer oder anderem wärmeleitfähigen Material. Zur gegenseitigen elektrischen Isolierung dieser Teile können oxidierte Oberflächen dienen.

Als Halbleitermaterial kommt z.B. BiTe in Betracht.

Im folgenden werden gleiche oder gleichwirkende Teile mit derselben Bezugszahl wie in den vorangehenden Figuren bezeichnet, wobei der betreffenden Bezugszahl jeweils der Buchstabe a bzw. b beigefügt ist.

Bei dem Ausführungsbeispiel von Fig. 6 sind Platten 6a und 6a' einer Stapelanordnung 17a jeweils aus zwei Lagen 15 und 15' gebildet, wobei die Lagen 15 und 15' in der montierten Thermobatterie miteinander durch leitfähigen Kleber, Schweißtechnik, Bondtechniken und dergleichen verbunden sein können. Diese Ausführungsform hat den Vorteil, dass Platten 16 mit p-leitenden und Platten 16' mit n-leitenden Halbleitern komplett vorgefertigt werden können.

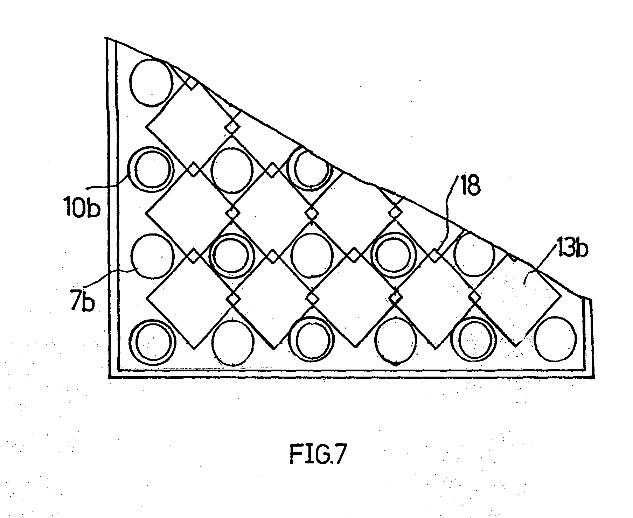

Fig. 7 zeigt eine weitere Möglichkeit zur Bildung von Platten 6b bzw. 6b'. Es sind im Eckenbereich 18 ineinander übergehende Kontaktflächen 13b für p- bzw. n-leitende Halbleiter vorgesehen, die jeweils an zwei Ecken eine der Übergangsstelle entsprechende Ausnehmung aufweisen. Durch eine solche Anordnung lässt sich eine noch größere Kontaktgesamtfläche und damit ein noch geringerer Innenwiderstand der Thermobatterie erreichen.

## Patentansprüche

1. Vorrichtung zur Erzeugung elektrischer Energie mit einer Vielzahl von Thermoelementen, die jeweils ein erstes Leiterstück (6), ein mit dem ersten Leiterstück verbundenes zweites Leiterstück (1;2) und ein drittes Leiterstück (6'), das mit dem zweiten Leiterstück (1;2) auf dessen dem ersten Leiterstück (6) gegenüberliegenden Seite verbunden ist, aufweist, wobei sich das Leitermaterial der ersten und dritten Leiterstücke (6,6') vom Leitermaterial der zweiten Leiterstücke (1;2) unterscheidet und die ersten Leiterstücke (6) mit einer Wärmequelle (11) und die dritten Leiterstücke (6') mit einer Wärmesenke (11') in Verbindung stehen, und eine Reihenanordnung der Thermoelemente vorgesehen ist, in welcher abwechselnd die ersten (6) und dritten (6') Leiterstücke der aufeinanderfolgenden Thermoelemente einander zugewandt sind,
**dadurch gekennzeichnet,**
**dass** die in der Reihenanordnung einander zugewandten Leiterstücke jeweils elektrisch miteinander verbunden und die zweiten Leiterstücke (1;2) der Thermoelemente abwechselnd aus einem, bezogen auf das Leitermaterial der zweiten und dritten Leiterstücke (6,6'), thermoelektrisch positiven und thermoelektrisch negativen Leitermaterial bestehen,
oder wobei die in der Reihenanordnung einander zugewandten Leiterstücke jeweils voneinander elektrisch isoliert und die dritten Leiterstücke jeweils mit dem ersten Leiterstück des in der Reihenanordnung folgenden Thermoelements elektrisch verbunden sind.

2. Vorrichtung nach Anspruch 1,
**dadurch gekennzeichnet,**
**dass** die in der Reihenanordnung einander zugewandten, elektrisch miteinander verbundenen Leiterstücke (6,6' ) unmittelbar ineinander übergehen.

3. Vorrichtung nach Anspruch 1 oder 2,
**dadurch gekennzeichnet,**
**dass** die in der Reihenanordnung einander zugewandten, elektrisch miteinander verbundenen Leiterstücke jeweils durch eine einzige Platte (6,6') gebildet sind.

4. Vorrichtung nach Anspruch 3,
**dadurch gekennzeichnet,**
**dass** zwischen den eine Stapelanordnung (17) bildenden Platten (6,6') jeweils eine Vielzahl von zweiten Leiterstücken (1 ;2) angeordnet ist.

5. Vorrichtung nach einem der Ansprüche 1 bis 4,
**dadurch gekennzeichnet,**
**dass** die zweiten Leiterstücke (1;2) abwechselnd durch einen p-leitenden (1) und einen n-leitenden (2) Halbleiter gebildet sind.

6. Vorrichtung nach einem der Ansprüche 1 bis 5,
**dadurch gekennzeichnet,**
**dass** die zweiten Leiterstücke (1;2) jeweils blockartig ausgebildet sind und über eine der Querschnittsfläche entsprechende Kontaktfläche mit dem ersten (6) und dritten (6') Leiterstück des jeweiligen Thermoelements in elektrischer Verbindung stehen.

7. Vorrichtung nach einem der Ansprüche 3 bis 6,
**dadurch gekennzeichnet,**
**dass** die Platten (6,6' ) mit der Wärmequelle (11) bzw. Wärmesenke (11') über die Stapelanordnung (17) durchsetzende Wärmeleitstäbe (8,8' ) verbunden sind, wobei die Wärmeleitstäbe (8,8') durch zueinander ausgerichtete, aufeinanderfolgende Öffnungen (7) in den Platten (6,6') geführt sind, wobei die Wärmeleitstäbe (8,8' ) abwechselnd im Wärmekontakt mit und wärmeisoliert gegen den Öffnungsrand, vorzugsweise im Abstand zum Öffnungsrand, durch die Öffnungen (7) geführt sind.

8. Vorrichtung nach Anspruch 7,
**dadurch gekennzeichnet,**
**dass** die Wärmeleitstäbe (8,8') direkt oder über elektrisch isolierende Wärmeleitringe (10) in Wärmekontakt mit dem Öffnungsrand stehen.

9. Vorrichtung nach Anspruch 7 oder 8,
**dadurch gekennzeichnet,**
**dass** in den Wärmeleitstäben (8,8') ein wärmetransportierendes Medium fließt.

10. Vorrichtung nach einem der Ansprüche 7 bis 9,
**dadurch gekennzeichnet,**
**dass** die Kontaktflächen (13) der zweiten Leiterstücke (1;2) quadratisch und die Öffnungen (7) kreisrund oder umgekehrt die Kontaktflächen kreisrund und die Öffnungen quadratisch sind.

11. Vorrichtung nach Anspruch 10,
**dadurch gekennzeichnet,**
**dass** die Öffnungen (7) in den Platten (6,6') in einem, vorzugsweise quadratischen, Raster angeordnet sind und ggf. die verlängerten Diagonalen der Kontaktflächen (13) der p- und n-leitenden Halbleiter die Quadratseiten halbieren.

12. Vorrichtung nach Anspruch 10 oder 11,
**dadurch gekennzeichnet,**
**dass** sich in Eckenbereichen (18) ineinander übergehende Kontaktflächen (13b) vorgesehen sind.

13. Vorrichtung nach einem der Ansprüche 1 bis 12,
**dadurch gekennzeichnet,**
**dass** die Platten (6a,6a') aus mehreren Lagen (15,15') gebildet sind.

14. Vorrichtung nach einem der Ansprüche 3 bis 13,
**dadurch gekennzeichnet,**
**dass** die zweiten Leiterstücke (1;2) mit den Platten (6,6'), insbesondere über ein leitfähiges Klebemittel, verbunden sind.

15. Vorrichtung nach einem der Ansprüche 1 bis 14,
**dadurch gekennzeichnet,**
**dass** die Wärmeleitstäbe (8,8') mit ihrem der Wärmequelle (11) bzw. Wärmesenke (11') abgewandten Ende in oder an einer zwischen der Quelle bzw. Senke und der Stapelanordnung (17) angeordneten Isolierschicht (14,14') enden.
